# EUROPÄISCHE PATENTSCHRIFT

(11) **EP 2 163 661 B1**
(45) Veröffentlichungstag und Bekanntmachung des Hinweises auf die Patenterteilung: **01.08.2012**
(21) Anmeldenummer: 08015741.5
(22) Anmeldetag: 05.09.2008
(51) Int. Cl.: C23C 14/06, C23C 14/32

(54) **Wälzfräswerkzeug mit einer Beschichtung und Verfahren zur Neubeschichtung eines Wälzfräswerkzeuges**
Hob tool with a coating and method for recoating a hob tool
Outil de fraisage à cylindre pourvu d'un revêtement et procédé de nouveau revêtement d'un outil de fraisage à cylindre

(43) Veröffentlichungstag der Anmeldung: 17.03.2010
(73) Patentinhaber: LMT Fette Werkzeugtechnik GmbH & Co. KG, 21493 Schwarzenbek (DE); Platit AG, 2540 Grenchen (CH)
(72) Erfinder: Morstein, Marcus, 2540 Grenchen (CH); Cselle, Tibor, 4515 Oberdorf (CH); Lümkemann, Andreas, 2540 Grenchen (CH); Kohlscheen, Jörn, 21493 Schwarzenbek (DE)
(74) Vertreter: Hauck Patent- und Rechtsanwälte

(56) Entgegenhaltungen:
- WO-A-2004/059030
- WO-A-2006/099754
- WO-A-2006/102780
- VETTER J ET AL: "(Cr:Al)N coatings deposited by the cathodic vacuum arc evaporation" SURFACE AND COATINGS TECHNOLOGY, ELSEVIER, AMSTERDAM, NL, Bd. 98, Nr. 1-3, 1. Januar 1998 (1998-01-01), Seiten 1233-1239, XP002347451 ISSN: 0257-8972

## Beschreibung

Die Erfindung betrifft einen Wälzfräser mit einer Beschichtung und ein Verfahren zur Beschichtung eines Wälzfräsers. Fräswerkzeuge, wie beispielsweise Wälzfräswerkzeuge, sind in der Praxis hohen Belastungen ausgesetzt. Dadurch kommt es zu einem verhältnismäßig hohen Verschleiß. Gerade Wälzfräswerkzeuge werden im Betrieb stark schlag- bzw. stoßbeansprucht.

Es ist bekannt, solche Werkzeuge mit einer an ihre Einsatzbedingungen angepassten Beschichtung, beispielsweise einer Hartstoffbeschichtung, zu versehen. Dazu kommen physikalische Gasphasenabscheidungsverfahren (Physical Vapor Deposition PVD) zum Einsatz. Für das Wälzfräsen und für andere zerspanende Arbeiten gelangten bisher in der Hauptsache einlagige Schichten, z. B. TiN- oder TiAIN-Schichten oder AlCrN zur Anwendung. Bei solchen Beschichtungen liegt über die Dicke eine konstante chemische Zusammensetzung vor. Es besteht allerdings insoweit ein Zielkonflikt, als einerseits für die Verschleißbeständigkeit möglichst harte Beschichtungen gewünscht sind, andererseits solche harten Schichten mechanische Spannungsspitzen in geringerem Maße abfedern können. Zu solchen Spannungsspitzen kommt es beispielsweise bei Bearbeitungsschritten mit unterbrochenem Schnitt. Dadurch können sich Risse durch die Werkzeugbeschichtung fortpflanzen und zum Versagen der Werkzeuge führen. Aus WO 2004/059030 A2 sind ein Werkstück mit einer AlCr-haltigen Hartstoffschicht und ein Verfahren zu seiner Herstellung bekannt. Dabei können sogenannte Gradientenschichten mit gegen die Oberfläche zunehmendem Al-Gehalt vorgesehen sein. Die Schichtzusammensetzung kann sich über die Schichtdicke kontinuierlich bzw. stufenweise ändern.

Den bekannten Beschichtungen ist gemein, dass sie hinsichtlich ihrer Verschleißbeständigkeit einerseits und ihrer Unempfindlichkeit gegen Schlag- und Stoßbeanspruchung andererseits nicht immer optimale Eigenschaften besitzen. Ein weiteres Problem stellt die Abfuhr von Spänen eines bearbeiteten Werkstücks dar. Zur Optimierung der Spanabfuhr ist es daher beispielsweise für Lichtbogen-PVD-Beschichtungen bekannt, die Beschichtungsoberfläche durch Nachbehandlung zu glätten. Dies stellt jedoch einen zusätzlichen Arbeitsschritt dar und verursacht entsprechende Kosten.

Für die Herstellung von Werkzeugbeschichtungen ist es aus WO 2004/059030 A2 bekannt, den metallischen Anteil der Hartstoffschicht aus legierten Quellen (sogenannten Targets) mit jeweils festen Zusammensetzungen zu verdampfen (z.B. AI:Cr-Zusammensetzungen). Aufgrund der festen Zusammensetzung der Targets ist jedoch die Flexibilität hinsichtlich der möglichen abscheidbaren Schichtkompositionen eingeschränkt.

Bei stark beanspruchten Werkzeugen, wie Wälzfräsern, verliert die Beschichtung durch Verschleiß nach einer gewissen Betriebsdauer ihre Funktion. Um in einem solchen Fall nicht das gesamte Werkzeug austauschen zu müssen, ist es erwünscht, nur die Beschichtung zu erneuern, also eine Wiederbeschichtung vorzunehmen. Dazu müssen zumindest Teile der mit der verschlissenen Beschichtung versehenen Werkzeugoberfläche abgetragen, beispielsweise abgeschliffen werden. Anschließend kann das Werkzeug wiederbeschichtet werden. Die nicht abgetragenen Oberflächenbereiche sind dabei allerdings im vorherigen Einsatz des Werkzeugs teils sehr hohen Temperaturen ausgesetzt gewesen. Aufgrund der dadurch bewirkten Veränderung dieser Bereiche kommt es zu einer teilweise ungenügenden Haftung der neuen Beschichtung. Dies wiederum führt dazu, dass die Beschichtung im Betrieb versagen, sich beispielsweise ablösen kann. Auch ist durch diese Problematik die Anzahl der möglichen Wiederbeschichtungen begrenzt.

Ausgehend von dem erläuterten Stand der Technik liegt der Erfindung die Aufgabe zugrunde, ein Wälzfräswerkzeug und ein Verfahren der eingangs genannten Art bereitzustellen, wobei in einfach herstellbarer Weise die Verschleißbeständigkeit einerseits und die Unempfindlichkeit gegen Schlag- oder Stoßbeanspruchung andererseits verbessert ist und die Wiederbeschichtbarkeit verbessert wird.

Diese Aufgabe wird gemäß der Erfindung durch die Gegenstände der unabhängigen Ansprüche 1 und 15 gelöst. Vorteilhafte Ausgestaltungen finden sich in den abhängigen Ansprüchen sowie der Beschreibung und der Zeichnung.

Für ein Wälzfräswerkzeug mit einer Beschichtung löst die Erfindung die Aufgabe dadurch, dass die Beschichtung durch ein physikalisches Gasphasenabscheidungsverfahren hergestellt ist, bei dem in einer Beschichtungskammer in einer stickstoffhaltigen Atmosphäre zwischen mindestens einer Anode einerseits und mindestens einer reinen Al-Kathode sowie mindestens einer reinen Cr-Kathode andererseits jeweils eine Lichtbogenentladung erzeugt und auf diese Weise Al und Cr aus den Kathoden verdampft wird, bei dem das zu beschichtende Wälzfräswerkzeug in der Beschichtungskammer rotiert, wobei es nacheinander an den mindestens zwei Kathoden vorbei geführt wird, und bei dem das verdampfte Al und Cr in atomarer oder ionisierter Form zusammen mit Stickstoff aus der stickstoffhaltigen Atmosphäre auf dem rotierend an den Kathoden vorbei geführten Wälzfräswerkzeug abgeschieden wird. Die Beschichtung weist eine Vielzahl von übereinander angeordneten Schichten aus (AlCr)-Nitriden auf, wobei die Vielzahl von Schichten aus zwei sich hinsichtlich ihres Al:Cr-Verhältnisses unterscheidenden Schichttypen gebildet ist, wobei ein erster Schichttyp ein Al:Cr-Verhältnis im Bereich von 55:45 bis 65:35, bevorzugt 60:40 bis 65:35, aufweist und ein zweiter Schichttyp ein Al:Cr-Verhältnis im Bereich von 70:30 bis 74:26 aufweist, und wobei die beiden Schichttypen einander in der Beschichtung abwechseln. Jede der Schichten ist wiederum aus einer Vielzahl von übereinander angeordneten Nanoschichten aufgebaut und die Beschichtung ist über eine Haftschicht mit dem Werkzeuggrundkörper verbunden.

Die Erfindung schlägt also einen viellagigen alternierenden nitridischen Hartstoffschichtaufbau für Wälzfräser vor. Durch eine Variation des Al:Cr-Verhältnisses, mittels geeigneter Steuerung der Prozessparameter, werden abwechselnd Schichten unterschiedlicher Härte und mit unterschiedlichen Eigenspannungen gebildet. Jede zweite Schicht besitzt dabei die gleiche AI:Cr-Zusammensetzung. Die Beschichtung ist also beispielsweise durch Schichtzusammensetzungen der Folge A-B-A-B- .... A-B gebildet.

Dabei wird erfindungsgemäß ein physikalisches Gasphasenabscheidungsverfahren eingesetzt, bei dem die zu beschichtenden Werkzeuge an mindestens zwei jeweils unlegierten Metall-Kathoden insbesondere vielfach vorbeigeführt werden. Dazu können die Werkzeuge beispielsweise auf einem in der Beschichtungskammer rotierenden Teller o.ä. angeordnet sein. Die Kathoden können beispielsweise im Zentrum des Tellers oder seitlich des Tellers angeordnet sein. Ein solches Beschichtungsverfahren und eine entsprechende Beschichtungsvorrichtung, die auch als Rundkathodenverfahren bzw. Rundkathodenvorrichtung bezeichnet werden, sind bekannt aus WO 02/050864 A1, EP 1 357 577 B1 oder WO 05/038077 A2. Durch die Verwendung reiner Metalltargets besteht im Gegensatz zur Verwendung legierter Targets eine hohe Flexibilität hinsichtlich der Einstellung der Zusammensetzung des abgeschiedenen Materials, z.B. durch eine geeignete Wahl der jeweils erzeugten Lichtbogenentladungen. Selbstverständlich können auch mehr als zwei reine Metalltargets vorgesehen sein, beispielsweise ein Chromtarget kombiniert mit zwei oder mehr Aluminiumtargets.

Die Beschichtungskammer ist dabei üblicherweise evakuiert (bzw. teilevakuiert). An das zu beschichtende Werkzeug wird meist ebenfalls eine (negative) elektrische Spannung angelegt, so dass die aus den Kathoden gelösten Ionen durch elektromagnetische Kräfte zum Werkzeug transportiert werden. Die Kathoden können zylindrisch sein und bspw. nebeneinander angeordnet sein, wobei ihre Zylinderachsen vertikal ausgerichtet sein können. Die Anode kann zwischen den Kathoden angeordnet sein. Es kann weiterhin jeweils eine magnetische Quelle (Elektromagnet und/oder Permanentmagnet) in den Kathoden vorgesehen sein, wobei sich die Kathoden und die ihr zugeordneten Magneten jeweils relativ zueinander drehen. Dabei ist es beispielsweise denkbar, dass sich die Kathoden drehen, während der Magnet feststeht. Es ist aber auch denkbar, dass sich die Magneten in den Kathoden drehen und die Kathoden feststehen. So wird das Kathodenmaterial gleichmäßig verdampft, da das rotierende Magnetfeld den Lichtbogen gleichmäßig über die Kathodenoberfläche führt. Üblicherweise wird dabei eine Vielzahl von auf einem rotierenden Werkzeughalter bzw. Werkzeugteller angeordneten Werkzeugen beschichtet.

Durch die Beimengung von Stickstoff aus der Gasphase werden die erfindungsgemäßen Nitride gebildet. Natürlich können neben Stickstoff aus der Atmosphäre in der Beschichtungskammer noch andere Bestandteile abgeschieden werden, beispielsweise Sauerstoff oder Kohlenstoff. Die erfindungsgemäß abwechselnden Al:Cr-Verhältnisse der Schichten werden erfindungsgemäß beispielsweise durch geeignete Einstellung der Lichtbogenentladungsströme zwischen der jeweiligen Kathode und mindestens einer Anode eingestellt. Dabei wird zuerst die erste Schicht mit dem gewünschten AI:Cr-Verhältnis beispielsweise durch Einstellung geeigneter Lichtbogenströme zwischen mindestens zwei Kathoden und mindestens einer Anode aufgebracht. Nachdem die erste Schicht mit der gewünschten Zusammensetzung und Dicke abgeschieden wurde, wird das Al:Cr-Verhältnis geändert, beispielsweise indem die Lichtbogenströme zu den Kathoden entsprechend verändert werden. Anschließend wird die zweite Schicht aufgetragen. Danach wird wieder die Zusammensetzung wie bei der ersten Schicht gewählt, und die dritte Schicht aufgetragen usw. bis die Beschichtung des erfindungsgemäßen Werkzeugs aufgebaut ist. Es ist dabei insbesondere möglich, dass in der Schichtzusammensetzung neben Al und Cr keine weiteren metallischen Bestandteile vorgesehen sind.

Durch das in geeigneter Weise nacheinander erfolgende Vorbeiführen der Werkzeuge an den Kathoden lassen sich in vorteilhafter Weise Nanoschichten ausbilden. Der Name der Nanoschichten leitet sich aus ihrer Dicke her. Insbesondere besitzen sie eine Dicke im Bereich weniger Nanometer. Im Extremfall können sie aus nur einer Molekül- bzw. Atomlage bestehen. Die Anzahl und Dicke der Nanoschichten pro Schicht lässt sich bei gegebenen Abmessungen der Kathoden und ihrer Anordnung in der Beschichtungskammer beispielsweise über die Rotationsgeschwindigkeit der Werkzeuge steuern.

Da aus den als Targets fungierenden unlegierten Kathoden jeweils nur eines der beiden Metalle Aluminium bzw. Chrom verdampft wird, kann sich auf den Werkzeugen insbesondere bei ihrem Vorbeiführen an der Al-Kathode mehr Aluminium und bei ihrem Vorbeiführen an der Cr-Kathode mehr Chrom niederschlagen.

Dadurch kann das Al:Cr-Verhältnis innerhalb einer Einzelschicht der Multilayer-Struktur im Sinne von Nanolagen moduliert sein. Die AI:Cr-Verhältnisse der Nanoschichten können sich dabei insbesondere periodisch ändern. Aufgrund der Nanoschichten kann also das AI:Cr-Verhältnis auch innerhalb der einzelnen Multilagen der Beschichtung variieren. Die Nanoschichten können sich auch in ihrer Kristallstruktur unterscheiden.

Über die jeweilige Schicht der Beschichtung gemittelt, liegt das Al:Cr-Verhältnis erfindungsgemäß zwischen 55:45 bis 65:35 bzw. 70:30 bis 74:26 und ist bei jeder 2. Schicht gleich. Es ist festgestellt worden, dass ein geringerer Al-Anteil die Härte der Einzellagen und die Wärmedämmwirkung der Schichten vermindert. Ein zu hoher Al-Anteil kann andererseits zu unerwünschten Kristallstrukturen führen. Sofern die Schichten außer Al und Cr keine weiteren metallischen Bestandteile aufweisen, liegt bezogen nur auf die metallischen Bestandteile der Aluminiumanteil für den ersten Schichttyp zwischen 55 und 65, und bevorzugt zwischen 60 und 65 Atom-%, und der Chromanteil zwischen 45 und 35, bevorzugt zwischen 40 und 35 Atom-% bzw. für den zweiten Schichttyp der Aluminiumanteil zwischen 70 und 74 und der Chromanteil zwischen 30 und 26 Atom-%. In der Gesamtzusammensetzung der Beschichtung kann dabei mehr als 30 Atom-%, beispielsweise ca. 50 Atom-%, Stickstoff vorhanden sein.

Durch die erfindungsgemäße Kombination von unterschiedlich harten Schichten mit unterschiedlichen Eigenspannungen, die wiederum aus einzelnen, sich in ihren Eigenschaften ebenfalls unterscheidenden Nanoschichten aufgebaut sind, wird eine flexible Einstellung der Beschichtung ermöglicht. So wird durch die erfindungsgemäße Kombination einer Vielzahl von Schichten und Nanoschichten einerseits ein hoher Abrasivwiderstand und somit eine hohe Verschleißbeständigkeit durch harte, allerdings zugleich spröde Schichten erreicht. Andererseits wird durch eine hohe Duktilität der relativ weicheren Schichten eine ausreichende Belastbarkeit bei Stoß- bzw. Schlagbeanspruchung, wie sie gerade beim Wälzfräsen auftritt, sichergestellt. Dadurch wird die Verschleißfestigkeit des Wälzfräswerkzeugs erhöht und insbesondere die Ausbreitungsneigung von Rissen in der Beschichtung oder das Ablösen der Beschichtung vermindert.

Auch bei einer Substraterweichung durch Wärmeeintrag während des Werkzeugeinsatzes (z.B. bei Werkzeugstählen) besitzt die erfindungsgemäße Beschichtung einen ausreichenden Widerstand gegen Einbruch bei Belastung durch abfließende Späne (sogenannter Eierschaleneffekt). Dies zu erreichen ist mit Einzelschichten schwierig. Die Beschichtung besitzt zudem eine ausreichende Wärmedämmwirkung und Oxidationsbeständigkeit. Dies wird durch den relativ hohen Aluminiumgehalt sichergestellt.

Weiterhin ist die Beschichtung erfindungsgemäß über eine insbesondere chemisch unterschiedliche Haftschicht mit dem Werkzeuggrundkörper verbunden. Eine solche Haftschicht verbessert die Anbindung der Beschichtung und verhindert sicher ein Ablösen der Beschichtung im Betrieb. Gleichzeitig führt die Haftschicht zu einer Stoßdämpfungswirkung bei Stoßbeanspruchung des Werkzeugs. Für die Haftschicht sind insbesondere Al-freie Metallnitride geeignet. Erfindungsgemäß ist erkannt worden, dass sich solche Schichten in einfacher Weise mit dem erfindungsgemäß verwendeten Verfahren unter Verwendung reiner Metallkathoden erzeugen lassen. Werden dagegen legierte Kathoden als Targets eingesetzt, ist die Erzeugung solcher Haftschichten nicht möglich. Die Dicke der Haftschicht kann beispielsweise kleiner als 1 µm sein.

Erfindungsgemäß ist erkannt worden, dass insbesondere (Voll-)Stahl- oder (Voll-) Hartmetall-Wälzfräswerkzeuge in vorteilhafter Weise mit der erfindungsgemäßen Beschichtung versehen werden können. Ihre Stoß- bzw. Schlagbeanspruchung im Betrieb kann in besonders vorteilhafter Weise bei gleichzeitig hoher Verschleißbeständigkeit erhöht werden. Der Einsatz der erfindungsgemäßen Beschichtung ist insbesondere denkbar für rotierende Werkzeuge, und dabei für Bearbeitungsverfahren mit unterbrochenem Schnitt, bei denen besonders hohe Spannungsspitzen auftreten. Die erfindungsgemäße Multilayer-Struktur bietet darüber hinaus bei der im unterbrochenen Schnitt auftretenden thermischen Wechselwirkungen Vorteile, inbesondere, wenn diese wie bei der Metallbearbeitung mit Kühlschmiestoffen z.B. Emulsionen ausgeprägt auftritt.

Als Haftschicht kann eine Chromnitrid-Schicht verwendet werden. Der Chromnitrid-Schicht wird insbesondere kein weiteres Metall zugesetzt. Chromnitrid-Schichten haben sich für die Anbindung als besonders geeignet erwiesen. Gleichzeitig kann eine Chromnitrid-Schicht in einfacher Weise erzeugt werden, indem aus der reinen Cr-Kathode Chrom in einer Stickstoffatmosphäre verdampft und gemeinsam mit dem Stickstoff auf dem Werkzeuggrundkörper abgeschieden wird, während die Al-Kathode nicht genutzt wird.

Die Dicke der einzelnen Schichten der Beschichtung kann beispielsweise in einem Bereich zwischen 0,05 und 0,5 µm liegen. Gemäß einer Ausgestaltung können die Schichten der beiden Schichttypen A und B der Beschichtung eine unterschiedliche Dicke besitzen. Chemisch unterschiedliche Schichten können also eine unterschiedliche Dicke aufweisen. Weiterhin wurde erfindungsgemäß erkannt, dass sich die Dicke einer oder beider Schichttypen A und B in Richtung der Beschichtungsoberfläche stetig oder stufenweise erhöhen oder verringern kann. Auf diese Weise ist eine noch flexiblere Einstellung der Eigenschaften der Beschichtung möglich.

Gemäß einer Ausgestaltung kann die äußerste Schicht der Beschichtung zu dem Schichttyp mit dem höheren Al-Anteil (zweiter Schichttyp) gehören. Es kann also für die im Einsatz des Werkzeugs mit dem zu bearbeitenden Werkstück in Kontakt kommende Schicht die härtere, verschleißbeständigere Schicht ausgewählt werden. Es ist aber auch möglich, dass die äußerste Schicht der Beschichtung zu dem Schichttyp mit dem geringeren Al-Anteil (erster Schichttyp) gehört. In diesem Fall gehört die äußerste Schicht zu dem weicheren, weniger zu Werkstückaufschmierungen neigenden Schichttyp. Entsprechend kann die innerste Schicht der Beschichtung zu dem Schichttyp mit dem geringeren Al-Anteil (erster Schichttyp) gehören. Die innerste Schicht weist also den geringeren Al-Anteil auf und ist entsprechend duktiler. Auf diese Weise wird eine besonders beständige Anbindung der Beschichtung an die Haftschicht bzw. den Werkzeuggrundkörper erreicht.

Gemäß einer weiteren Ausgestaltung kann auf der obersten Schicht der Beschichtung eine reibungsmindernde und/oder andersfarbige Deckschicht vorgesehen sein. Die Deckschicht kann beispielsweise eine Dicke von 0,1 bis 1 µm aufweisen. Reibungsmindernd bedeutet in diesem Zusammenhang, dass aufgrund der Zusammensetzung und Oberflächenstruktur der Deckschicht bei beispielsweise auf der Deckschicht abfließenden Metallspänen ein geringerer Reibungskoeffizient besteht als es bei einem Abfließen auf den übrigen Schichten der Beschichtung der Fall wäre. Auf diese Weise wird der Spanabtransport optimiert und es besteht eine geringere Adhäsionsneigung zum bearbeiteten Werkstück. Eine Beschädigung durch Späne wird vermieden. Indem die Deckschicht eine andere Farbe aufweisen kann, wird eine besonders einfache Verschleißerkennung gewährleistet. Eine andere Farbe kann auch aus Gründen der Ästhetik gewünscht sein. Die Deckschicht kann beispielsweise eine kohlenstoffhaltige Schicht und/oder eine Me-Schicht sein, wobei Me = Cr, Ti oder Zr. So kann als Deckschicht beispielsweise eine AlMe-Nitrid-Schicht zum Einsatz kommen. Als kohlenstoffhaltige Schicht kann beispielsweise MeNC (z.B. CrNC) oder AIMeNC zum Einsatz kommen. Der Kohlenstoff in den Verbindungen verringert den Reibungskoeffizienten. Im Gegensatz zum Stand der Technik ist bei Verwendung der erfindungsgemäßen Deckschicht somit keine zusätzliche Glättung der Beschichtungsoberfläche mehr erforderlich. Die Herstellung wird vereinfacht. Durch ein Abschalten der Metalltargets, beispielsweise ein Abschalten der den Metalltargets zugeführten Lichtbogenströme oder ein gezieltes Abdecken einer oder mehrerer Metallkathoden durch eine geeignete Abdeckung (Shutter), lässt sich auch eine metallfreie kohlenwasserstoffhaltige Schicht abscheiden, die besonders reibungsarm ist. Die Me-Schicht kann auch eine intermetallische Schicht sein, z.B. eine AlMe-Schicht, bevorzugt eine AlCr-Schicht. Diese kann beispielsweise silberfarben sein. Intermetallische Verbindungen weisen eine verhältnismäßig hohe Härte und einen geringen Reibwert auf. Als Deckschicht auch denkbar ist eine MeNO-Schicht (z.B. CrNO).

Zur Herstellung kann die Deckschicht wiederum durch physikalische Gasphasenabscheidung aufgebracht werden. Das Element Kohlenstoff kann beispielsweise zugemischt werden, indem gegen Ende des Beschichtungsvorgangs zusätzlich zu der Stickstoffatmosphäre ein kohlenstoffhaltiges Gas in gewünschter Menge (z. B. Methan, Acetylen usw.) in die Beschichtungskammer eingelassen wird. Durch beliebige Mischungsverhältnisse von Stickstoff zu kohlenstoffhaltigem Gas kann eine nahezu beliebige Elementzusammensetzung C:N erzielt werden. Metallfreie kohlenwasserstoffhaltige Schichten lassen sich beispielsweise durch Abschalten der Metallquellen bei der Gasphasenabscheidung erzielen. Zur Herstellung einer nitridfreien Metalldecklage, beispielsweise aus Aluminium und einem anderen Metall, kann entsprechend die Zuleitung von Stickstoff in die Kammer während der Beschichtung unterbrochen werden.

Die Deckschicht kann eine gradierte Zusammensetzung besitzen. Unter einer gradierten Zusammensetzung ist zu verstehen, dass sich die chemische Zusammensetzung über einen Bereich graduell oder kontinuierlich ändert. Durch Ausführung beispielsweise des Übergangs zwischen zwei Werkstoffbereichen mit einer gradierten Zusammensetzung können Spannungsspitzen weitgehend vermieden werden. Zur Herstellung der gradierten Zusammensetzung kann beispielsweise die zwischen einem Metalltarget und der Anode für die Lichtbogenerzeugung angelegte elektrische Spannung schrittweise oder kontinuierlich verändert werden oder in die Beschichtungskammer eingelassenes Gas schrittweise oder kontinuierlich in seiner Menge verändert werden.

Die Schichten (Schichten der beiden Schichttypen A und B und/oder Deckschicht) können weiterhin Silizium aufweisen, wobei der Anteil an Silizium zwischen 0,1 und 2,0 Atom-% der metallischen Bestandteile der Schichten betragen kann. In diesem Fall weisen die Schichten neben Aluminium und Chrom also als weiteres Element Silizium auf. Bezogen auf die metallischen Bestandteile der Schicht (also insbesondere ohne den Stickstoffanteil), in diesem Fall also Aluminium, Chrom und Silizium, kann Silizium dann einen Anteil von 0,1 bis 5,0 Atom-% aufweisen. Die Zugabe von Silizium führt zu einer weiter verbesserten Oxidationsbeständigkeit und thermischen Isolation.

Erfindungsgemäß ist erkannt worden, dass der scheinbare Zielkonflikt bei der Herstellung von Wälzfräserbeschichtungen durch eine hohe Anzahl von Schichten besonders gut lösbar ist. Entsprechend kann die erfindungsgemäße Beschichtung mehr als 10, bevorzugt mehr als 30, weiter bevorzugt mehr als 45 Schichten aufweisen. Werden beispielsweise mindestens 60 Schichten für die Beschichtung eingesetzt, lassen sich weitgehend optimierte Eigenschaften erreichen. Die einzelnen Schichten können wiederum aus mehr als 5, bevorzugt mehr als 15 weiter bevorzugt mehr als 25 Nanoschichten aufgebaut sein.

Die Schichten der Beschichtung können in der kubischen Kristallstruktur vorliegen bzw. abgeschieden werden. Die kubische Kristallstruktur zeichnet sich durch eine hohe Härte aus und ist insofern beispielsweise gegenüber der weicheren hexagonalen Kristallstruktur bevorzugt. Für die Kombination AlCr liegt der maximale Al-Anteil zum Erreichen der kubischen Kristallstruktur bezogen auf die metallischen Bestandteile bei etwa 72 Atom-%.

Wälzfräser weisen scharfe Schneidkanten für die Bearbeitung auf. Gemäß einer weiteren Ausgestaltung der Erfindung können die Schneidkanten des Wälzfräswerkzeugs vor dem Aufbringen der Beschichtung verrundet werden. Derart abgerundete Schneidkanten lassen sich besser beschichten. Insbesondere werden die Haftung der Beschichtung bzw. der Haftschicht sowie die mechanische Stabilität der beschichteten Schneidkante verbessert.

Die Aufgabe wird gemäß der Erfindung außerdem gelöst durch ein Verfahren zur Wiederbeschichtung eines erfindungsgemäßen Wälzfräswerkzeugs, bei dem die wieder zu beschichtende Werkzeugoberfläche zumindest teilweise abgetragen, insbesondere abgeschliffen, wird, auf die wieder zu beschichtende Werkzeugoberfläche mit dem physikalischen Gasphasenabscheidungsverfahren eine Cr-Nitrid-Haftschicht aufgebracht wird, indem in stickstoffhaltiger Atmosphäre nur zwischen der mindestens einen Anode und der mindestens einen reinen Cr-Kathode eine Lichtbogenentladung erzeugt und auf diese Weise Cr aus der Kathode verdampft wird, und indem das Wälzfräswerkzeug in der Beschichtungskammer rotiert, wobei es zumindest an der Cr-Kathode vorbei geführt wird, so dass das verdampfte Cr zusammen mit Stickstoff auf dem Wälzfräswerkzeug kondensiert. Anschließend wird auf die Cr-Nitrid-Haftschicht ebenfalls mit dem physikalischen Gasphasenabscheidungsverfahren eine erfindungsgemäße Beschichtung aufgebracht. Das physikalische Gasphasenabscheidungsverfahren kann dabei insbesondere das Verfahren sein, mit dem das erfindungsgemäße Wälzfräswerkzeug beschichtet wurde.

Bei dem Verfahren können nach dem Abtragen der wieder zu beschichtenden Werkzeugoberfläche und vor dem Wiederbeschichten die Schneidkanten des Werkzeugs durch geeignete Verfahren, inbesondere Nass- oder Trockenstrahlen, präpariert, insbesondere verrundet, werden. Nach dem Abtragen der wieder zu beschichtenden Werkzeugoberfläche bzw. gegebenenfalls nach einem Präparieren der Schneidkanten und vor dem Wiederbeschichten kann das Wälzfräswerkzeug gereinigt werden.

Erfindungsgemäß ist erkannt worden, dass durch die Verwendung von reinen Metallkathoden das insbesondere bei Wälzfräswerkzeugen bestehende Problem der Wiederbeschichtung gelöst werden kann, indem nur aus der reinen Cr-Kathode Chrom verdampft und zusammen mit Stickstoff aus der Gasphase zu einer Cr-Nitrid-Haftschicht auf der zumindest teilweise abgetragenen Oberfläche des Werkzeugs abgeschieden wird. Eine solche Cr-Nitrid-Haftschicht lässt sich mit herkömmlichen legierten Targets nicht aufbringen. Die Haftschicht bewirkt eine verbesserte Anbindung der Beschichtung auch auf den nicht abgetragenen Oberflächenabschnitten, die ansonsten aufgrund ihrer durch die Bearbeitung erzeugten Oberflächenveränderungen schlecht zu beschichten sind. Dadurch wird auch die Anzahl der möglichen Wiederbeschichtungen erhöht. Es kann dabei deutlich mehr als die Hälfte der zu beschichtenden Oberfläche unabgetragen belassen werden. Durch das Abtragen werden vorrangig oxidierte Oberflächenbereiche abgetragen.

Ein Ausführungsbeispiel der Erfindung wird nachfolgend anhand einer Zeichnung näher erläutert. Es zeigen schematisch:
- Fig. 1: ein erfindungsgemäßes Wälzfräswerkzeug mit einer Beschichtung,
- Fig. 2: ein Standzeit-Balkendiagramm gemäß einem ersten Beispiel,
- Fig. 3: ein Standzeit-Balkendiagramm gemäß einem zweiten Beispiel, und
- Fig. 4: ein Standzeit- und Verschleiß-Balkendiagramm gemäß einem dritten Beispiel.

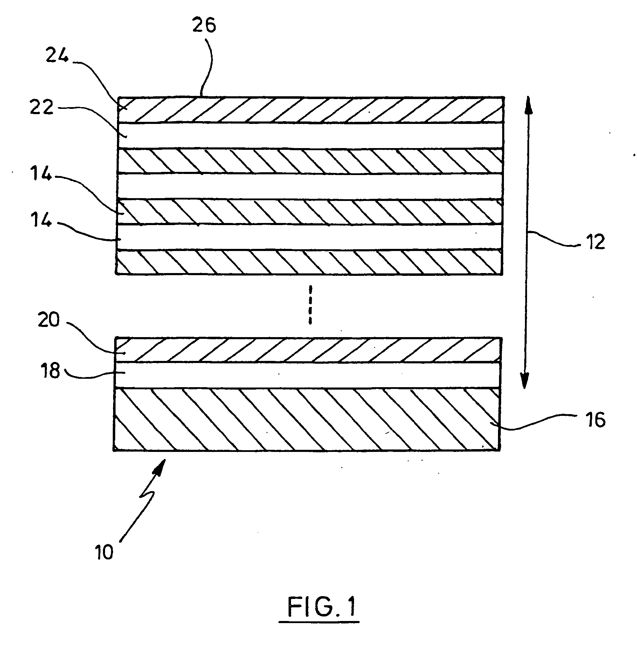

In Figur 1 ist ein erfindungsgemäßes Wälzfräswerkzeug 10 schematisch und ausschnittsweise dargestellt. Das Wälzfräswerkzeug 10 weist eine Beschichtung 12 aus einer Vielzahl von übereinander angeordneten Schichten 14 auf. Auf dem Werkzeuggrundkörper 16 ist zunächst eine Haftschicht 18, vorliegend eine CrN-Schicht 18 aufgebracht. Die Haftschicht 18 verbessert die Anbindung der übrigen Schichten und besitzt gleichzeitig eine stoßdämpfende Wirkung. Auf der Haftschicht 18 ist eine erste AlCr-Nitridschicht 20 aufgebracht. Die erste AlCr-Nitridschicht ist von einem ersten Schichttyp und besitzt ein erstes Al:Cr-Verhältnis im Bereich von 60:40 bis 65:35. Auf der ersten Schicht 20 ist eine zweite, in Figur 1 nicht näher dargestellte AlCr-Nitridschicht eines zweiten Schichttyps aufgebracht, die ein zweites, unterschiedliches Al:Cr-Verhältnis im Bereich von 69,5:30,5 bis 72:28 besitzt. Auf der zweiten AlCr-Nitridschicht ist eine dritte AlCr-Nitridschicht 20 wiederum vom ersten Schichttyp aufgebaut, die in ihrer Zusammensetzung der ersten AlCr-Nitridschicht 20 gleicht und auf der dritten AlCr-Nitridschicht 20 eine vierte AlCr-Nitridschicht 22 vom zweiten Schichttyp, die in ihrer Zusammensetzung der zweiten AlCr-Nitridschicht gleicht. Dieser Aufbau setzt sich über die Beschichtung 12 fort. Jede der AlCr-Nitridschichten besteht wiederum aus einer Vielzahl von in Figur 1 nicht näher dargestellten übereinander angeordneten Nanoschichten. Die Nanoschichten können beispielsweise eine Dicke von weniger als 20 nm besitzen.

Tabelle 1 zeigt typische Eigenschaften der erfindungsgemässen Schichten. Die Härtewerte und Elastizitätsmodule wurden durch Nanohärtemessungen mit einer Prüflast von 30 bis 70 mN erhalten. Es ist erkennbar, dass die AICrN-Multilagenschichten gegenüber dem Stand der Technik, in Form von speziell für das Wälzfräsen entwickelten Monoblock- oder Gradientenschichten, eine sehr hohe Härte mit sehr hohem E-Modul kombinieren, was eine verbesserte Verschleissbesständigkeit erwarten lässt.. Die AlCrN-Multilayer-Variante Beispiel 1 besitzt anspruchsgemäss einen durchschnittlichen mittleren Al-Gehalt, Beispiel 2 einen gegenüber Beispiel 1 erhöhten mittleren Al-Gehalt und eine reduzierte Schichtdicke der Einzellagen.

**Tabelle 1**

| **Beschichtungstyp** | **H[GPa]** | **E[GPa]** |
|---|---|---|
| Referenz 1, AlCrSiN Gradient | 37.3 | 435 |
| Referenz 2, AlCrN-Monoblock | 35.7 | 588 |
| AlCrN-Multilayer Beispiel 1 | 35.7 | 569 |
| ACrN-Multilayer Beispiel 2 | 38.4 | 582 |

In dem dargestellten Beispiel sind sechzig Schichten 14 aus AlCr-Nitriden übereinander angeordnet. Dabei wechseln sich die beiden erläuterten Schichttypen beim Aufbau der Beschichtung ab. Jede der sechzig Schichten 14 besteht wiederum aus mehr als 25 Nanoschichten. Die AlCr-Nitridschichten 20, 22 der Beschichtung 12 liegen sämtlich in der kubischen Kristallstruktur vor. Auf der obersten Schicht 22 der Beschichtung 12 ist eine reibungsmindernde und andersfarbige Deckschicht 24 vorgesehen. In dem dargestellten Beispiel handelt es sich um eine kohlenstoffhaltige Schicht 24. Sie vermindert die Reibung bei der Bearbeitung eines Werkstücks mit dem Wälzfräswerkzeug 10. Insbesondere führt sie zu einer optimierten Spanabfuhr von der Werkzeugoberfläche 26.

Das Wälzfräswerkzeug 10 mit der erfindungsgemäßen Beschichtung 12 wird durch physikalische Gasphasenabscheidung (PVD) hergestellt, wie dies beispielsweise in WO 02/050864 A1, EP 1 357 577 B1 oder WO 05/038077 A2 beschrieben ist. Dabei sind in einer nicht näher dargestellten PVD-Beschichtungskammer unterschiedliche reine Metallkathoden, in dem dargestellten Beispiel zylindrische reine Al- und Cr-Kathoden nebeneinander angeordnet. Mittels einer Lichtbogenentladung zwischen mindestens einer Anode und den Kathoden kann Al und Cr in einer gewünschten Menge aus den jeweiligen Kathoden als Targets gelöst werden. Gleichzeitig kann in die Beschichtungskammer Stickstoff oder ein kohlenstoffhaltiges Gas eingelassen werden. Zur Herstellung der Haftschicht 18 wird Cr nur aus der Cr-Kathode gelöst und Stickstoff in die Beschichtungskammer eingeleitet. Aus der Al-Kathode wird dabei kein Aluminium gelöst. Dazu kann die Al-Kathode beispielsweise mittels einer Abdeckung abgedeckt werden. Es wird somit eine CrN-Schicht auf dem Werkzeuggrundkörper 16 abgeschieden. Anschließend werden unter Aufrechterhaltung der Stickstoffatmosphäre mittels Lichtbogenentladung Al und Cr aus den reinen Al- und Cr-Targets gelöst, so dass eine AlCr-Nitridschicht auf der Haftschicht 18 abgeschieden wird. Die Zusammensetzung dieser Schicht hinsichtlich ihres AlCr-Verhältnisses wird dabei durch geeignete Lichtbogenströme zu den Al- und Cr-Targets gewählt. In analoger Weise kann anschließend die zweite Schicht 22, die ebenfalls eine AlCr-Nitridschicht 22 ist, mit ihrer AlCr-Zusammensetzung auf der ersten Schicht 20 abgeschieden werden usw. Sofern zusätzlich Silizium abgeschieden werden soll, kann in der Beschichtungskammer noch eine mit Silizium legierte Kathode vorgesehen sein. Zum abschließenden Aufbringen einer beispielsweise kohlenstoffhaltigen Deckschicht 24 kann ein kohlenstoffhaltiges Gas, z. B. Methan oder Acetylen, in die Beschichtungskammer eingelassen werden. Der Kohlenstoff wird dann in der Deckschicht 24 abgeschieden.

Verschiedene erfindungsgemäße Werkzeuge 10 mit erfindungsgemäßen Beschichtungen 12 ("Multilayer-Beschichtungen") wurden hinsichtlich ihrer Standzeiten bzw. ihres Verschleißes mit Werkzeugen mit einer konventionellen einlagigen AlCrN-Beschichtung ("Monolayer-Beschichtung") unter jeweils gleichen Bearbeitungsbedingungen verglichen. Die konventionelle einlagige Beschichtung wies in den folgenden drei Beispielen jeweils ein AI:Cr-Verhältnis von 69:31 auf. Für die drei Beispiele sind die entsprechenden Versuchsparameter in den folgenden drei Tabellen dargestellt.

**Tabelle 2:**

| Werkzeug: | Wälzfräser |
|---|---|
| | PM-HSS |
| | Modul 2,7 |
| | |
| Werkstück: | 20MnCrB5 |
| | weich |
| | |
| Bearbeitung: | Trocken |
| | v_{c} = 220 m/min |
| | fₐ = 3,6 mm/WU |
| | |

| AlCrN Multilayer-Beschichtung Variante 1: | |
|---|---|
| 60 Schichten | Al:Cr |
| 1. Schichttyp: | 64:36 |
| 2. Schichttyp: | 70:30 |
| Decklage | 70:30 |

**Tabelle 3:**

| Werkzeug: | Wälzfräser |
|---|---|
| | Hartmetall K20 |
| | Modul 2,7 |
| | |
| Werkstück: | 20MnCrB5 |
| | weich |
| | |
| Bearbeitung: | Trocken |
| | v_{c} = 380 m/min |
| | fₐ = 3 mm/WU |
| | |

| AlCrN Multilayer-Beschichtung Variante 1: | |
|---|---|
| 60 Schichten | Al:Cr |
| 1. Schichttyp: | 64:36 |
| 2. Schichttyp: | 70:30 |
| Decklage | 70:30 |

**Tabelle 4:**

| Werkzeug: | Wälzfräser |
|---|---|
| | PM-HSS |
| | Modul 1,6 |
| | |
| Werkstück: | 16MnCr5 |
| | weich |
| | |
| Bearbeitung: | Trocken |
| | v_{c} = 190 m/min |
| | fₐ = 2,1 mm/WU |
| | |

| AlCrN Multilayer-Beschichtung Variante 2: | |
|---|---|
| 45 Schichten | Al:Cr |
| 1. Schichttyp: | 60:40 |
| 2. Schichttyp: | 70:30 |
| Decklage | 70:30 |

Dabei wurden Wälzfräser aus unterschiedlichen Grundmaterialien mit einer erfindungsgemäßen Beschichtung bei der Bearbeitung von Werkstücken, vorliegend dem Wälzfräsen, aus unterschiedlichen Materialien untersucht. Bei den bearbeiteten Werkstücken handelte es sich in den dargestellten Beispielen um Zahnräder. Die Bearbeitung erfolgte jeweils trocken, also ohne Zugabe von Kühlschmierstoffflüssigkeit. v_{c} bedeutet die Schnittgeschwindigkeit in m/min und fₐ der Vorschub in mm/Werkzeugumdrehung (WU). Die erfindungsgemäßen Beschichtungen (Multilayer-Beschichtungen) waren jeweils aus einer Vielzahl von AlCrN-Schichten aufgebaut (60 bzw. 45 Schichten), wobei sich jeweils zwei sich hinsichtlich ihres Al:Cr-Verhältnisses unterscheidende Schichten in der Beschichtung abwechseln. In den untersuchten Beispielen wiesen die Schichten jeweils die gleiche Dicke auf. Jede der erfindungsgemäßen Schichten war wiederum aus einer Vielzahl von Nanoschichten aufgebaut. Die erfindungsgemäßen Beschichtungen waren mit einer AlCrN-Deckschicht versehen, die jeweils ein Al:Cr-Verhältnis von 70:30 aufwiesen.

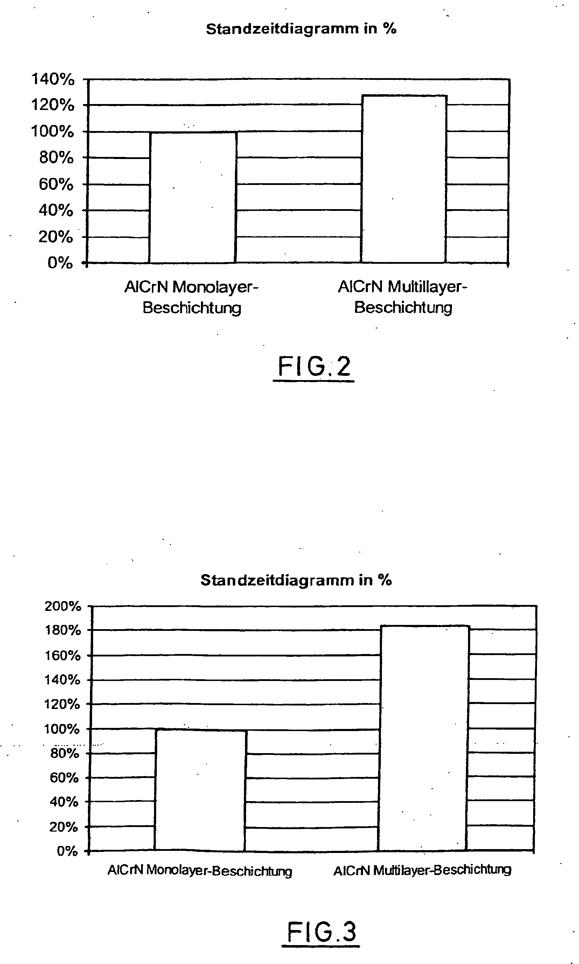

In den Figuren 2 bis 4 sind die Versuchsergebnisse diagrammatisch veranschaulicht. In den Figuren 2 und 3 sind jeweils Standzeitdiagramme in % dargestellt, in denen die Standzeiten der erfindungsgemäß beschichteten Werkzeuge ("AlCrN Multilayer-Beschichtung") mit den konventionell beschichteten Werkzeugen ("AlCrN Monolayer-Beschichtung") verglichen wurden. Dabei wurde die Standzeit des konventionellen Werkzeugs für den Vergleich jeweils auf 100% normiert. Es ist zu erkennen, dass die erfindungsgemäß beschichteten Werkzeuge unter denselben Bearbeitungsbedingungen eine deutlich höhere Standzeit besitzen als die konventionellen Werkzeuge (ca. 130% bzw. ca. 185%).

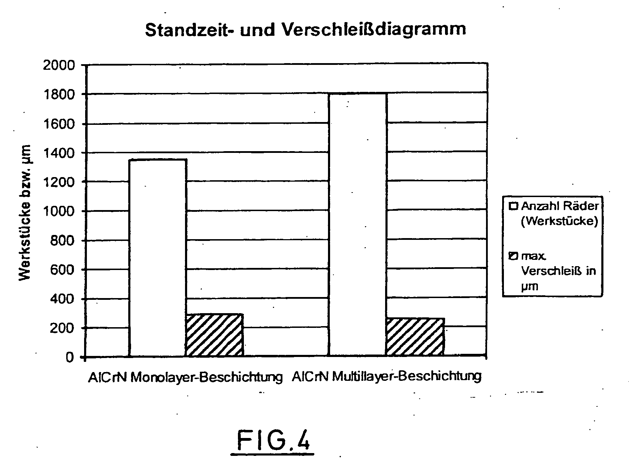

In Figur 4 ist ein Standzeit- und Verschleißdiagramm dargestellt. Auf der Y-Achse des Diagramms sind die Anzahl der mit den Werkzeugen maximal bearbeitbaren Werkstücke einerseits und der dabei auftretende maximale Verschleiß der Werkzeuge in µm andererseits aufgetragen. Die diagonal schraffiert dargestellten Balken zeigen den Verschleiß in µm für die konventionelle Monolayer-Beschichtung einerseits und die erfindungsgemäße Multilayer-Beschichtung andererseits. Die beiden weiteren Balken in Fig. 4 zeigen die Anzahl von mit den beiden verglichenen Werkzeugen bearbeitbaren Werkstücken (Zahnrädern) an. Es ist zu erkennen, dass mit dem konventionell beschichteten Werkzeug weniger als 1400 Werkstücke bearbeitbar waren, während mit dem erfindungsgemäß beschichteten Werkzeug 1800 Werkstücke bearbeitbar waren. Weiter ist zu erkennen, dass das konventionell beschichtete Werkzeug einen maximalen Verschleiß von ca. 300µm aufwies, während das erfindungsgemäß beschichtete Werkzeug einen Verschleiß von ca. 250µm aufwies.

## Patentansprüche

1. Wälzfräswerkzeug mit einer Beschichtung,
wobei die Beschichtung (12) durch ein physikalisches Gasphasenabscheidungsverfahren hergestellt ist,
- bei dem in einer Beschichtungskammer in einer stickstoffhaltigen Atmosphäre zwischen mindestens einer Anode einerseits und mindestens einer reinen Al-Kathode sowie mindestens einer reinen Cr-Kathode andererseits jeweils eine Lichtbogenentladung erzeugt und auf diese Weise Al und Cr aus den Kathoden verdampft wird,
- bei dem das zu beschichtende Wälzfräswerkzeug (10) in der Beschichtungskammer rotiert, wobei es nacheinander an den mindestens zwei Kathoden vorbei geführt wird, und
- bei dem das verdampfte Al und Cr in atomarer oder ionisierter Form zusammen mit Stickstoff aus der stickstoffhaltigen Atmosphäre auf dem rotierend an den Kathoden vorbei geführten Wälzfräswerkzeug (10) abgeschieden wird,
wobei die Beschichtung eine Vielzahl von übereinander angeordneten Schichten (14) aus (AlCr)-Nitriden aufweist, wobei die Vielzahl von Schichten (14) aus zwei sich hinsichtlich ihres Al:Cr-Verhältnisses unterscheidenden Schichttypen (20, 22) gebildet ist, wobei ein erster Schichttyp ein Al:Cr-Verhältnis im Bereich von 55:45 bis 65:35, bevorzugt 60:40 bis 65:35 aufweist und ein zweiter Schichttyp ein Al:Cr-Verhältnis im Bereich von 70:30 bis 74:26 aufweist, und wobei die beiden Schichttypen (20, 22) einander in der Beschichtung (12) abwechseln,
wobei jede der Schichten (14) wiederum aus einer Vielzahl von übereinander angeordneten Nanoschichten aufgebaut ist, und
wobei die Beschichtung (12) über eine Haftschicht (18) mit dem Werkzeuggrundkörper (16) verbunden ist.

2. Wälzfräswerkzeug nach Anspruch 1, **dadurch gekennzeichnet, dass** die Haftschicht (18) eine Chromnitrid-Schicht ist.

3. Wälzfräswerkzeug nach einem der Ansprüche 1 oder 2, **dadurch gekennzeichnet, dass** die Schichten der Beschichtung eine unterschiedliche Dicke besitzen.

4. Wälzfräswerkzeug nach Anspruch 3, **dadurch gekennzeichnet, dass** die Dicke der Schichten sich in Richtung der Beschichtungsoberfläche stetig oder stufenweise erhöht oder verringert.

5. Wälzfräswerkzeug nach einem der vorhergehenden Ansprüche, **dadurch gekennzeichnet, dass** die äußerste Schicht der Beschichtung (12) zu dem zweiten Schichttyp (20, 22) gehört.

6. Wälzfräswerkzeug nach einem der vorhergehenden Ansprüche, **dadurch gekennzeichnet, dass** die innerste Schicht der Beschichtung (12) zu dem ersten Schichttyp (20, 22) gehört.

7. Wälzfräswerkzeug nach einem der vorhergehenden Ansprüche, **dadurch gekennzeichnet, dass** auf der äußersten Schicht der Beschichtung (12) eine reibungsmindernde und/oder andersfarbige Deckschicht (24) vorgesehen ist.

8. Wälzfräswerkzeug nach Anspruch 7, **dadurch gekennzeichnet, dass** die Deckschicht (24) eine kohlenstoffhaltige Schicht (24) und/oder eine metallische Schicht ist.

9. Wälzfräswerkzeug nach einem der Ansprüche 7 oder 8, **dadurch gekennzeichnet, dass** die Deckschicht (24) eine gradierte Zusammensetzung besitzt.

10. Wälzfräswerkzeug nach einem der vorhergehenden Ansprüche, **dadurch gekennzeichnet, dass** die Schichten (14) weiterhin Silizium aufweisen, wobei der Anteil an Silizium zwischen 0,1 und 2,0 Atom-% der metallischen Bestandteile der Schichten (14) beträgt.

11. Wälzfräswerkzeug nach einem der vorhergehenden Ansprüche, **dadurch gekennzeichnet, dass** die Beschichtung (12) mehr als 10, bevorzugt mehr als 30, weiter bevorzugt mehr als 45 Schichten (14) aufweist.

12. Wälzfräswerkzeug nach einem der vorhergehenden Ansprüche, **dadurch gekennzeichnet, dass** die Schichten (14) der Beschichtung (12) in der kubischen Kristallstruktur vorliegen.

13. Wälzfräswerkzeug nach einem der vorhergehenden Ansprüche, **dadurch gekennzeichnet, dass** die Schneidkanten des Wälzfräswerkzeugs (10) vor dem Aufbringen der Beschichtung (12) durch ein geeignetes Verfahren verrundet wurden.

14. Wälzfräswerkzeug nach einem der Ansprüche 1 bis 13, **dadurch gekennzeichnet, dass** die Beschichtung unter Verwendung von zylindrischen, rotierenden Arc-PVD-Kathoden hergestellt wurde.

15. Verfahren zur Wiederbeschichtung eines Wälzfräswerkzeugs nach einem der vorhergehenden Ansprüche, umfassend die folgenden Schritte:
a) die wieder zu beschichtende Werkzeugoberfläche wird zumindest teilweise abgetragen, insbesondere abgeschliffen,
b) auf die wieder zu beschichtende Werkzeugoberfläche wird mit dem physikalischen Gasphasenabscheidungsverfahren eine Cr-Nitrid-Haftschicht aufgebracht, indem in stickstoffhaltiger Atmosphäre nur zwischen der mindestens einen Anode und der mindestens einen reinen Cr-Kathode eine Lichtbogenentladung erzeugt und auf diese Weise Cr aus der Kathode verdampft wird, und indem das Wälzfräswerkzeug (10) in der Beschichtungskammer rotiert, wobei es zumindest an der Cr-Kathode vorbei geführt wird, so dass das verdampfte Cr zusammen mit Stickstoff auf dem Wälzfräswerkzeug kondensiert,
c) auf die Cr-Nitrid-Haftschicht wird anschließend ebenfalls mit dem physikalischen Gasphasenabscheidungsverfahren eine Beschichtung (12) mit einer Vielzahl von übereinander angeordneten Schichten (14) aus (AlCr)-Nitriden aufgebracht, wobei die Vielzahl von Schichten (14) aus zwei sich hinsichtlich ihres Al:Cr-Verhältnisses unterscheidenden Schichttypen (20, 22) gebildet ist, wobei ein erster Schichttyp ein Al:Cr-Verhältnis im Bereich von 60:40 bis 65:35 aufweist und ein zweiter Schichttyp ein Al:Cr-Verhältnis im Bereich von 69,5:30,5 bis 72:28 aufweist, und wobei die beiden Schichttypen (20, 22) einander in der Beschichtung (12) abwechseln, wobei jede der Schichten (14) wiederum aus einer Vielzahl von übereinander angeordneten Nanoschichten aufgebaut ist.

16. Verfahren nach Anspruch 15, **dadurch gekennzeichnet, dass** die Beschichtung unter Verwendung von zylindrischen, rotierenden Arc-PVD-Kathoden durchgeführt wird.

17. Verfahren nach Anspruch 15 oder Anspruch 16, **dadurch gekennzeichnet, dass** nach dem Abtragen der wieder zu beschichtenden Werkzeugoberfläche und vor dem Wiederbeschichten die Schneidkanten des Wälzfräswerkzeugs (10) durch geeignete Verfahren, inbesondere. Nass- oder Trockenstrahlen, präpariert, insbesondere verrundet, werden.

18. Verfahren nach einem der Ansprüche 15 bis 17, **dadurch gekennzeichnet, dass** das Wälzfräswerkzeug (10) nach dem Abtragen der wieder zu beschichtenden Werkzeugoberfläche bzw. gegebenenfalls nach dem Präparieren der Schneidkanten und vor dem Wiederbeschichten gereinigt wird.

19. Verfahren nach einem der Ansprüche 15 bis 18, **dadurch gekennzeichnet, dass** eine Beschichtung (12) nach einem der Ansprüche 1 bis 14 aufgebracht wird.

## Claims

1. A hob tool with a coating,
wherein the coating (12) is produced through a physical vapor deposition method,
- in which in a coating chamber in a nitrogen containing atmosphere an arc discharge is generated in each case between at least one anode on the one hand, and at least one pure Al cathode and at least one pure Cr cathode on the other hand, and in this manner, Al and Cr are vaporized from the cathodes,
- in which the hob tool (10) to be coated rotates in the coating chamber, wherein it is guided subsequently past the at least two cathodes, and
- in which the vaporized Al and Cr is deposited in atomic or ionic form together with nitrogen from the nitrogen containing atmosphere onto the rotating hob tool (10) being guided past the cathodes,
wherein the coating has a multiplicity of layers (14) arranged on top of each other, composed of (AlCr)-nitride, wherein the multiplicity of layers (14) is formed from two layer types (20, 22) differing with respect to their Al:Cr ratio, wherein a first layer type has an Al:Cr ratio in the range of 55:45 to 65:35, preferably 60:40 to 65:35, and a second layer type has an Al:Cr ratio in the range of 70:30 to 74:26, and wherein the two layer types (20, 22) alternate with each other in the coating (12),
wherein each of the layers (14) in turn is formed from a multiplicity of nanolayers arranged on top of each other, and
wherein the coating (12) is connected to the tool base body (16) via a bonding layer (18).

2. The hob tool according to claim 1, **characterized in that** the bonding layer (18) is a chrome nitride layer.

3. The hob tool according to one of the Claims 1 or 2, **characterized in that** the layers of the coating have a different thickness.

4. The hob tool according to claim 3, **characterized in that** the thickness of the layers increases or decreases continuously or step-wise in the direction of the coating surface.

5. The hob tool according to one of the preceding claims, **characterized in that** the outermost layer of the coating (12) belongs to the second layer type (20, 22).

6. The hob tool according to one of the preceding claims, **characterized in that** the innermost layer of the coating (12) belongs to the first layer type (20, 22).

7. The hob tool according to one of the preceding claims, **characterized in that** a friction reducing and/or differently colored cover layer (24) is provided on the outermost layer of the coating (12).

8. The hob tool according to claim 7, **characterized in that** the cover layer (24) is a carbon containing layer (24) and/or a metallic layer.

9. The hob tool according to one of the claims 7 or 8, **characterized in that** the cover layer (24) has a graded composition.

10. The hob tool according to one of the preceding claims, **characterized in that** the layers (14) additionally have silicon, wherein the portion of silicon amounts to between 0.1 and 2.0 atomic % of the metallic components of the layers (14).

11. The hob tool according to one of the preceding claims, **characterized in that** the coating (12) has more than 10, preferably more than 30, particularly preferably more than 45 layers (14).

12. The hob tool according to one of the preceding claims, **characterized in that** the layers (14) of the coating (12) are present in the cubic crystal structure.

13. The hob tool according to one of the preceding claims, **characterized in that** the cutting edges of the hob tool (10) are rounded by a suitable method before the application of the coating (12).

14. The hob tool according to one of the claims 1 to 13, **characterized in that** the coating is produced using cylindrical, rotating arc PVD cathodes.

15. A method for recoating a hob tool according to one of the preceding claims, comprising the following steps:
a) the tool surface to be coated again is at least partially removed, in particular, abraded,
b) on the tool surface to be coated again, a Cr nitride bonding layer is applied using the physical vapor deposition method, in that an arc discharge is generated in a nitrogen containing atmosphere only between the at least one anode and the at least one pure Cr cathode, and in this manner Cr is vaporized from the cathode, and in that the hob tool (10) rotates in the coating chamber, wherein it is guided at least past the Cr cathode, such that the vaporized Cr together with the nitrogen condense onto the hob tool,
c) a coating (12) with a multiplicity of layers (14), composed of (AlCr) nitride, arranged on top of each other, is then applied onto the Cr nitride bonding layer, also using the physical vapor deposition method, wherein the multiplicity of layers (14) is formed from two layer types (20, 22) differing with respect to their Al:Cr ratios, wherein a first layer type has an Al:Cr ratio in the range of 60:40 to 65:35 and a second layer type has an Al:Cr ratio in the range of 69.5:30.5 to 72:28, and wherein the two layer types (20, 22) alternate with each other in the coating (12), wherein each of the layers (14) is formed from a multiplicity of nanolayers arranged on top of each other.

16. The method according to claim 15, **characterized in that** the coating is performed using cylindrical, rotating arc PVD cathodes.

17. The method according to claim 15 or claim 16, **characterized in that** after the removal of the tool surface to be coated again and before the recoating, the cutting edges of the hob tool (10) are prepared, in particular, rounded, by suitable methods, especially wet or dry blasting.

18. The method according to one of the claims 15 to 17, **characterized in that** the hob tool (10) is cleaned after the removal of the tool surface to be coated again, or if applicable, after the preparation of the cutting edges and before the recoating.

19. The method according to one of the claims 15 to 18, **characterized in that** a coating (12) is applied according to one of the claims 1 to 14.

## Revendications

1. Outil de fraisage à cylindre pourvu d'un revêtement,
le revêtement (12) étant réalisé par un procédé physique de dépôt en phase gazeuse,
- dans lequel, dans une chambre de revêtement, dans une atmosphère azotée, une décharge en arc est produite respectivement entre au moins une anode d'un côté et au moins une pure cathode Al ainsi qu'au moins une pure cathode Cr d'un autre côté, et Al et Cr sont vaporisés à partir des cathodes,
- dans lequel l'outil de fraisage à cylindre (10) à revêtir tourne dans la chambre de revêtement, cet outil étant guidé pour passer successivement devant les cathodes au moins au nombre de deux, et
- dans lequel Al et Cr vaporisés sont déposés sous forme atomique ou ionisée en même temps que l'azote issu de l'atmosphère azotée sur l'outil de fraisage à cylindre (10) conduit à passer devant les cathodes tout en tournant,
le revêtement présentant une multiplicité de couches (14) de nitrures (AlCr), disposées les unes au-dessus des autres, la multiplicité de couches (14) étant formée de deux types de couche (20, 22) se distinguant en ce qui concerne leur rapport Al:Cr, un premier type de couche présentant un rapport Al:Cr dans la plage de 55:45 à 65:35, de préférence de 60:40 à 65:35, et un deuxième type de couche présentant un rapport Al:Cr dans la plage de 70:30 à 74:26, et les deux types de couche (20, 22) alternant mutuellement dans le revêtement (12),
chacune des couches (14) étant à son tour constituée d'une multiplicité de nanocouches disposées les unes au-dessus des autres, et
le revêtement (12) étant raccordé au corps de base d'outil (16) par le biais d'une couche adhésive (18).

2. Outil de fraisage à cylindre selon la revendication 1, **caractérisé en ce que** la couche adhésive (18) est une couche de nitrure de chrome.

3. Outil de fraisage à cylindre selon une des revendications 1 ou 2, **caractérisé en ce que** les couches du revêtement possèdent une épaisseur différente.

4. Outil de fraisage à cylindre selon la revendication 3, **caractérisé en ce que** l'épaisseur des couches augmente ou diminue en direction de la surface du revêtement, constamment ou par étapes.

5. Outil de fraisage à cylindre selon une des revendications précédentes, **caractérisé en ce que** la couche la plus extérieure du revêtement (12) appartient au deuxième type de couche (20, 22).

6. Outil de fraisage à cylindre selon une des revendications précédentes, **caractérisé en ce que** la couche la plus intérieure du revêtement (12) appartient au premier type de couche (20, 22).

7. Outil de fraisage à cylindre selon une des revendications précédentes, **caractérisé en ce que**, sur la couche la plus extérieure du revêtement (12), il est prévu une couche de couverture (24) diminuant la friction et/ou d'une autre couleur.

8. Outil de fraisage à cylindre selon la revendication 7, **caractérisé en ce que** la couche de couverture (24) est une couche contenant du carbone (24) et/ou une couche métallique.

9. Outil de fraisage à cylindre selon une des revendications 7 ou 8, **caractérisé en ce que** la couche de couverture (24) possède une composition graduée.

10. Outil de fraisage à cylindre selon une des revendications précédentes, **caractérisé en ce que** les couches (14) présentent également du silicium, la proportion de silicium étant comprise entre 0,1 et 2,0 % atomique des composants métalliques des couches (14).

11. Outil de fraisage à cylindre selon une des revendications précédentes, **caractérisé en ce que** le revêtement (12) présente plus de 10, de préférence plus de 30, encore plus de préférence plus de 45 couches (14).

12. Outil de fraisage à cylindre selon une des revendications précédentes, **caractérisé en ce que** les couches (14) du revêtement (12) se présentent sous forme de structure cristalline cubique.

13. Outil de fraisage à cylindre selon une des revendications précédentes, **caractérisé en ce que**, avant l'application du revêtement (12), les arêtes de coupe de l'outil de fraisage à cylindre (10) ont été arrondies par un procédé approprié.

14. Outil de fraisage à cylindre selon une des revendications 1 à 13, **caractérisé en ce que** le revêtement a été réalisé en utilisant des cathodes Arc-PVD cylindriques rotatives.

15. Procédé de nouveau revêtement d'un outil de fraisage à cylindre selon une des revendications précédentes, comprenant les étapes suivantes :
a) la surface d'outil à revêtir de nouveau est enlevée au moins partiellement, en particulier par meulage,
b) une couche adhésive de nitrure de Cr est appliquée avec le procédé physique de dépôt en phase gazeuse sur la surface d'outil à revêtir de nouveau, par la production d'une décharge en arc, dans une atmosphère azotée, uniquement entre l'anode au moins au nombre de un et la pure cathode Cr au moins au nombre de un, et par la vaporisation ainsi effectuée de Cr à partir de la cathode, et en faisant tourner l'outil de fraisage à cylindre (10) dans la chambre de revêtement, l'outil étant guidé pour passer au moins devant la cathode Cr de sorte que le Cr vaporisé est condensé en même temps que l'azote sur l'outil de fraisage à cylindre,
c) ensuite, également avec le procédé physique de dépôt en phase gazeuse, un revêtement (12) est appliqué sur la couche adhésive de nitrure Cr, avec une multiplicité de couches (14) de nitrures (AlCr) disposées les unes au-dessus des autres, la multiplicité de couches (14) étant formée de deux types de couche (20, 22) se distinguant en ce qui concerne leur rapport Al:Cr, un premier type de couche présentant un rapport Al:Cr dans la plage de 60:40 à 65:35, et un deuxième type de couche présentant un rapport Al:Cr dans la plage de 69,5:30,5 à 72:28, et les deux types de couche (20, 22) alternant mutuellement dans le revêtement (12), chacune des couches (14) étant à son tour composée d'une multiplicité de nanocouches disposées les unes au-dessus des autres.

16. Procédé selon la revendication 15 , **caractérisé en ce que** le revêtement est effectué en utilisant des cathodes Arc-PVD cylindriques rotatives.

17. Procédé selon la revendication 15 ou la revendication 16, **caractérisé en ce que**, après l'enlèvement de la surface d'outil à revêtir de nouveau et avant l'application du nouveau revêtement, les arêtes de coupe de l'outil de fraisage à cylindre (10) sont préparées, en particulier arrondies, par des procédés appropriés, en particulier par décapage par voie humide ou à sec.

18. Procédé selon une des revendications 15 à 17, **caractérisé en ce que** l'outil de fraisage à cylindre (10) est nettoyé après l'enlèvement de la surface d'outil à revêtir de nouveau ou respectivement éventuellement après la préparation des arêtes de coupe et avant la nouvelle opération de revêtement.

19. Procédé selon une des revendications 15 à 18, **caractérisé en ce qu'**un revêtement (12) est appliqué selon une des revendications 1 à 14.
